# EUROPÄISCHE PATENTANMELDUNG

(11) **EP 3 865 962 A1**
(43) Veröffentlichungstag der Anmeldung: **18.08.2021**
(21) Anmeldenummer: 21151750.3
(22) Anmeldetag: 15.01.2021
(51) Int. Cl.: G05B 23/02, G01R 31/00

(54) **DIAGNOSEVERFAHREN UND DIAGNOSEEINRICHTUNG FÜR EINE ANLAGE**

(30) Priorität: 13.02.2020 DE 102020201792
(71) Anmelder: Siemens Mobility GmbH, 81739 München (DE)
(72) Erfinder: Blum, Karsten, 38106 Braunschweig (DE); Sauter, Witali, 38116 Braunschweig (DE)

(57) **Zusammenfassung**

Die Erfindung betrifft ein Diagnoseverfahren für eine Anlage, insbesondere für eine verkehrstechnische Anlage (1), bei dem wenigstens ein Diagnoseziel (2) der Anlage (1) als wenigstens ein Diagnoseobjekt (5) abgebildet wird, bei dem Daten zu wenigstens einer Eigenschaft des Diagnoseziels (2) für das Diagnoseobjekt (5) von wenigstens einer Datenquelle (4) zur Verfügung gestellt werden, und bei dem für die wenigstens eine Datenquelle (4) wenigstens eine Validitätsprüfung (11) durchgeführt wird. Das erfindungsgemäße Diagnoseverfahren hat den Vorteil, dass ein Ausfall einer Datenquelle (4) festgestellt werden kann. Die Erfindung betrifft auch eine Diagnoseeinrichtung (3).

## Beschreibung

Diagnoseverfahren und Diagnoseeinrichtungen sind aus dem Stand der Technik für verschiedene Arten von Anlagen, wie beispielsweise verkehrstechnische Anlagen oder eisenbahntechnische Anlagen, bekannt.

Gerade bezüglich einer vorausschauenden Wartung der Anlage (predictive maintenance) sind Diagnoseeinrichtungen und Diagnoseverfahren sehr wichtig. Dabei wird beispielsweise innerhalb eines Computersystems für die zu diagnostizierenden Teile der Anlage, die im Folgenden als Diagnoseziel bezeichnet werden, Datenobjekte modelliert, im Folgenden auch Diagnoseobjekte genannt werden, die die Diagnoseziele repräsentieren. Dabei werden Daten zu verschiedenen Eigenschaften des Diagnoseziels zur Verfügung gestellt, um das Diagnoseobjekt modulieren zu können. Das Diagnoseobjekt kann hierbei Daten aus verschiedenen Datenquellen verarbeiten und zusammensetzen. Problematisch kann es hierbei sein, wenn eine Datenquelle eine Störung hat oder ausfällt. In diesem Fall kann es zur Anzeige von veralteten oder gar keinen Daten kommen, durch die wiederum ein Bediener zu falschen Schlussfolgerungen kommen kann.

Der Erfindung liegt daher die Aufgabe zugrunde, ein Diagnoseverfahren und eine Diagnoseeinrichtung für eine Anlage bereitzustellen, die auch bei einem Ausfall oder einer Störung der Datenquelle zuverlässig weiterarbeiten.

Die Aufgabe wird erfindungsgemäß durch ein Diagnoseverfahren für eine Anlage gelöst, insbesondere für eine verkehrstechnische Anlage, bei dem wenigstens ein Diagnoseziel der Anlage als wenigstens ein Diagnoseobjekt abgebildet wird, bei dem Daten zu wenigstens einer Eigenschaft des Diagnoseziels für das Diagnoseobjekt von wenigstens einer Datenquelle zur Verfügung gestellt werden, und bei dem für die wenigstens eine Datenquelle wenigstens eine Validitätsprüfung durchgeführt wird.

Weiterhin löst die Erfindung die Aufgabe durch eine Diagnoseeinrichtung für eine Anlage, insbesondere für eine verkehrstechnische Anlage, mit wenigstens einem Diagnoseobjekt, das zum Abbilden von wenigstens einem Diagnoseziel der Anlage und zum Verarbeiten von Daten zu wenigstens einer Eigenschaft des Diagnoseziels ausgebildet ist, wobei die Diagnoseeinrichtung ausgebildet ist, die Daten zu der wenigstens einen Eigenschaft des Diagnoseziels von wenigstens einer Datenquelle zu verarbeiten, und mit wenigstens einer Prüfeinrichtung, die zum Durchführen wenigstens einer Validitätsprüfung für die wenigstens eine Datenquelle ausgebildet ist.

Die erfindungsgemäße Lösung hat den Vorteil, dass eine Invalidität der Datenquelle erkannt wird und entsprechende weitere Maßnahmen ergriffen werden können. Invalidität soll hier und im Folgenden bedeuten, dass die Validitätsprüfung nicht erfolgreich war. Wenn die Invaliditätsprüfung erfolgreich war, wird von einer validen Datenquelle gesprochen.

Die Erfindung kann durch weitere vorteilhafte Ausgestaltung weiterentwickelt werden, die im Folgenden beschrieben sind.

So kann ein Ergebnis der Validitätsprüfung und ein Prüfzeitpunkt der Validitätsprüfung abgespeichert werden. Dies hat den Vorteil, dass das Ergebnis und/oder der Prüfzeitpunkt für einen Bediener auch später noch angezeigt oder anderweitig verwendet werden kann.

Um einen Bediener möglichst gut und eindeutig zu informieren, kann bei einem vorbestimmten Ergebnis der Validitätsprüfung eine vorbestimmte Anzeige am Diagnoseobjekt abgebildet werden. Beispielsweise kann bei festgestellter Invalidität der Datenquelle dies in Form eines entsprechenden Schriftzuges oder vorbestimmten Zeichens für einen Bediener erkennbar angezeigt werden. Zusätzlich kann als zumindest ein Teil der Anzeige der Prüfzeitpunkt der Validitätsprüfung abgebildet werden. Dies hat den Vorteil, dass der Bediener anhand des Prüfzeitpunkts eigene Schlüsse ziehen kann und die Anzeige entsprechend bewerten kann.

Ferner kann als Teil der Validitätsprüfung eine Verbindung zur Datenquelle geprüft werden. Dies hat den Vorteil, dass hierdurch eine von mehreren Ursachen einer Invalidität festgestellt werden kann. Zusätzlich oder alternativ kann als Teil der Validitätsprüfung wenigstens eine Regel und/oder ein Algorithmus zur Berechnung der Datenvalidität angewendet werden. Wenn beispielsweise eine Stromversorgung oder ein Netzwerkswitch ausfällt, können sämtliche an die Stromversorgung und den Netzwerkswitch angeschlossenen Geräte keine validen Datenwerte mehr liefern, obwohl die Geräte möglicherweise technisch in Ordnung sind. Ohne Strom funktionieren die Geräte allerdings nicht bzw. ohne Netzverbindung können sie keine Daten liefern. Ein entsprechender Algorithmus bzw. eine entsprechende Regel erkennt dies und kann bei der Validitätsprüfung einen invaliden Zustand feststellen.

Um das Diagnoseobjekt und die darin angezeigten Eigenschaften möglichst aktuell zu halten, kann die Validitätsprüfung im Wesentlichen kontinuierlich oder regelmäßig durchgeführt werden.

Für bestmögliche Bedienerinformationen können bei einer festgestellten Invalidität der Datenquelle trotzdem die letzten zur Verfügung gestellten Daten verwendet und angezeigt werden.

Die Erfindung betrifft weiterhin auch ein Computerprogramm mit Programmbefehlen zur Durchführung des erfindungsgemäßen Diagnoseverfahren nach einer der oben genannten Ausführungsformen. Mit Hilfe des erfindungsgemäßen Computerprogrammproduktes sind jeweils das erfindungsgemäße Verfahren und/oder dessen Ausführungsbeispiele durchführbar.

Darüber hinaus wird eine Bereitstellungsvorrichtung zum Speichern und/oder Bereitstellen des Computerprogrammproduktes beansprucht. Die Bereitstellungsvorrichtung ist beispielsweise ein Datenträger, der das Computerprogrammprodukt speichert und/oder bereitstellt. Alternativ und/oder zusätzlich ist die Bereitstellungsvorrichtung beispielsweise ein Netzwerkdienst, ein Computersystem, ein Serversystem, insbesondere ein verteiltes Computersystem, cloudbasiertes Rechnersystem und/oder virtuelles Rechnersystem, welches das Computerprogrammprodukt vorzugsweise in Form eines Datenstroms speichert und/oder bereitstellt.

Die Bereitstellung erfolgt beispielsweise als Download in Form eines Programmdatenblocks und/oder Befehlsdatenblocks, vorzugsweise als Datei, insbesondere als Downloaddatei, oder als Datenstrom, insbesondere als Downloaddatenstrom, des vollständigen Computerprogrammprodukts. Diese Bereitstellung kann beispielsweise aber auch als partieller Download erfolgen, der aus mehreren Teilen besteht und insbesondere über ein Peer-to-Peer Netzwerk heruntergeladen oder als Datenstrom bereitgestellt wird. Ein solches Computerprogrammprodukt wird beispielsweise unter Verwendung der Bereitstellungsvorrichtung in Form des Datenträgers in ein System eingelesen und führt die Programmbefehle aus, sodass das erfindungsgemäße Verfahren auf einem Computer zur Ausführung gebracht wird.

In einer vorteilhaften Ausgestaltung der erfindungsgemäßen Diagnoseeinrichtung kann diese wenigstens eine Speichereinrichtung aufweisen, in der wenigstens ein Ergebnis der Validitätsprüfung und/oder ein Prüfzeitpunkt der Validitätsprüfung abgespeichert sind. Dies hat den Vorteil, dass das Ergebnis und der Prüfzeitpunkt auch nach der Prüfung noch sehr leicht verfügbar und abrufbar sind.

Um am Diagnoseobjekt für einen Bediener auch bei Ausfall einer Datenquelle möglichst viele Informationen bereitzustellen, kann die Diagnoseeinrichtung ausgebildet sein, bei einer festgestellten Invalidität der Datenquelle die letzten zur Verfügung gestellten Daten zu verwenden.

Schließlich betrifft die Erfindung auch eine verkehrstechnische Anlage mit wenigstens einem Diagnoseziel, mit wenigstens zwei Datenquellen, die jeweils zum Liefern von Daten zu wenigstens einer Eigenschaft des Diagnoseziels ausgebildet sind und mit wenigstens einer Diagnoseeinrichtung. Erfindungsgemäß ist die Diagnoseeinrichtung der verkehrstechnischen Anlage nach einer zuvor genannten erfindungsgemäßen Ausführungsformen ausgebildet.

Vorteilhafterweise ist die Anlage als eisenbahntechnische Anlage ausgebildet, da die Erfindung hierfür gut einsetzbar ist.

Im Folgenden wird die Erfindung mit Bezug auf die beigefügten Zeichnungen erläutert.

Es zeigen:
- Fig. 1: eine schematische Darstellung einer beispielhaften Ausführungsform einer erfindungsgemäßen eisenbahntechnischen Anlage mit einer erfindungsgemäßen Diagnoseeinrichtung;
- Fig. 2: eine schematische Darstellung der Diagnoseeinrichtung aus Fig. 1 in einem anderen Zustand.

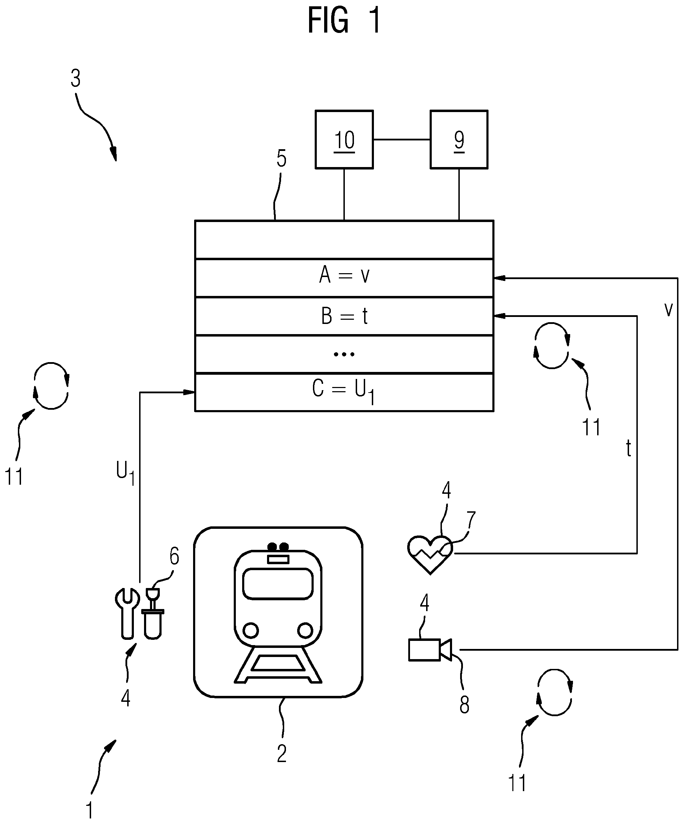

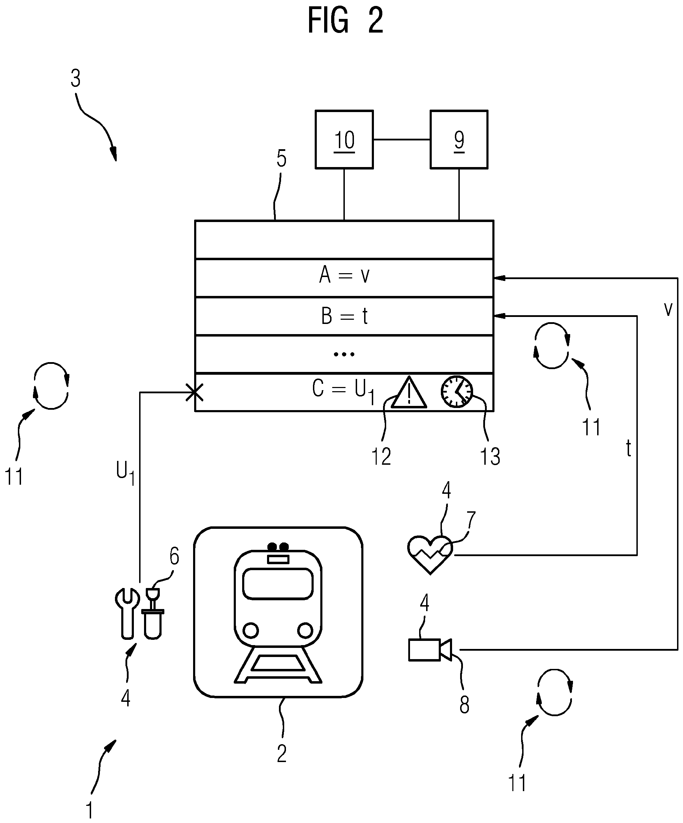

Eine eisenbahntechnische Anlage 1 umfasst in der beispielhaften Ausführungsform der Figuren 1 und 2 ein Diagnoseziel 2, eine Diagnoseeinrichtung 3 und mehrere Datenquellen 4. Die eisenbahntechnische Anlage 1 ist in bekannter Weise ausgestaltet und umfasst beispielsweise Fahrzeuge und Feldelemente wie Weichen, Lichtsignale, Stellwerke, etc. Sämtliche dieser Anlagenteile der eisenbahntechnischen Anlage 1 können diagnostiziert werden und dadurch jeweils Diagnoseziele 2 darstellen. Der Einfachheit halber ist in den Figuren 1 und 2 lediglich ein Diagnoseziel 2 dargestellt, das hier beispielsweise ein Schienenfahrzeug sein soll.

Die erfindungsgemäße Diagnoseeinrichtung 3 ist beispielsweise auf einem oder mehreren Computern ausgebildet und zur Diagnose der eisenbahntechnischen Anlage 1 und dabei insbesondere des Diagnoseziels 2 ausgebildet. Wie schon erwähnt, ist in den Figuren der Einfachheit halber lediglich ein Diagnoseziel 2 dargestellt. Ansonsten werden durch die erfindungsgemäße Diagnoseeinrichtung 3 selbstverständlich eine Vielzahl von Diagnosezielen 2 diagnostiziert. Hierfür umfasst die Diagnoseeinrichtung 3 eine Vielzahl von Diagnoseobjekten 5, wobei in den Figuren ebenfalls der Einfachheit halber lediglich ein Diagnoseobjekt in den Figuren 1 und 2 dargestellt ist.

Für jedes Diagnoseziel 2 wird üblicherweise ein Diagnoseobjekt 5 moduliert. Das Diagnoseobjekt 5 in den Figuren 1 und 2 wird mit Daten von verschiedenen Datenquellen 4 gespeist. Die Daten der Datenquellen 4 beziehen sich auf unterschiedliche Eigenschaften A, B, C des Diagnoseziels 2. In der beispielhaften Ausführungsform der Figuren 1 und 2 ist die Eigenschaft A beispielsweise eine Geschwindigkeit v, die Eigenschaft B eine Temperatur t und die Eigenschaft C eine Spannung U₁.

Als Datenquellen 4 dienen bei der bespielhaften Ausführungsform in den Figuren 1 und 2 eine Diagnoseschnittstelle 6 des Schienenfahrzeugs, ein Spannungs- und Temperatursensor 7 und ein Geschwindigkeitssensor 8.

Die Diagnoseeinrichtung 3 umfasst weiterhin eine Speichereinrichtung 9 und eine Prüfeinrichtung 10. Die Prüfeinrichtung 10 führt im Betrieb regelmäßig oder sogar kontinuierlich eine oder mehrere Validitätsprüfungen für jede Datenquelle 4 durch. Das Ergebnis jeder Validitätsprüfung und ein Prüfzeitpunkt zu jeder Valditätsprüfung wird in der Speichereinrichtung 9 abgespeichert.

Wie in den beispielhaften Ausführungsformen in den Figuren 1 und 2 zu erkennen, wird für jede Datenquelle 4 jeweils eine Validitätsprüfung 11 durchgeführt. Bei der beispielhaften Ausführungsform in den Figuren 1 und 2 wird an das Diagnoseobjekt 5 von der Diagnoseschnittstelle 6 eine Spannung U₁ geliefert. In dem in Fig. 2 dargestellten Zustand hat die Validitätsprüfung ergeben, dass diese Datenquelle 4 invalide ist, weil beispielsweise die Datenverbindung gestört ist. Daraufhin wird im Diagnoseobjekt 5 eine vorbestimmte Anzeige 12 in Form eines Warndreiecks angezeigt, die dem Benutzer die Invalidität dieser Datenquelle 4 signalisiert. Trotzdem wird für die Eigenschaft C immer noch die Spannung U₁ angezeigt, die bei der letzten erfolgreichen Validitätsprüfung gemessen wurde. Zusätzlich wird der abgespeicherte Prüfzeitpunkt 13 der letzten erfolgreichen Validitätsprüfung in Form eines Zeitstempels angezeigt.

Der Ausfall der Diagnoseschnittstelle 6 kann beispielsweise dadurch verursacht sein, weil die Stromversorgung der Diagnoseschnittstelle 6 oder ein Netzwerkswitch in der Datenleitung zum Diagnoseobjekt 5 ausgefallen ist. Durch beide Ursachen können keine Daten mehr zum Diagnoseobjekt geliefert werden. Dabei ist es unerheblich ob die Diagnoseschnittstelle 6 selbst noch in Ordnung und gegebenenfalls sogar betriebsbereit ist. Die Prüfeinrichtung 10 umfasst hierfür entsprechende Regler und/oder Algorithmen, die die Invalidität einer Datenquelle 4 feststellen. Diese können beispielsweise eine Regel oder ein Algorithmus zur Prüfung eines Ausfalls einer Stromversorgung der Datenquelle 4 sein, eine Regel oder ein Algorithmus zur Prüfung eines Ausfalles eines Netzwerkswitches oder eine Regel oder ein Algorithmus zur Prüfung eines Ausfalls einer Netzwerkverbindung.

Selbstverständlich kann zusätzlich auch bei erfolgreicher Validitätsprüfung, also wenn die Validität der entsprechenden Datenquelle 4 festgestellt worden ist, eine entsprechende Anzeige (nicht dargestellt) über dieses Ergebnis gezeigt werden. Weiterhin kann bei festgestellter Invalidität einer Datenquelle 4 zusätzlich auch noch der Grund der Invalidität angezeigt werden, wenn dieser durch die Prüfeinrichtung 10 ermittelt wurde. Wenn beispielsweise ermittelt wurde, dass ein Netzwerkswitch ausgefallen ist, kann ein entsprechender Text oder ein Symbol angezeigt werden, der oder das einem Benutzer zeigt, dass die Datenverbindung zur Datenquelle 4 gestört ist. Diese Information kann beispielsweise für den Benutzer hilfreich sein, damit er einfacher entscheiden kann, ob der letzte gültige Wert von ihm als hilfreich eingestuft wird.

## Patentansprüche

1. Diagnoseverfahren für eine Anlage, insbesondere für eine verkehrstechnische Anlage (1),
bei dem wenigstens ein Diagnoseziel (2) der Anlage (1) als wenigstens ein Diagnoseobjekt (5) abgebildet wird,
bei dem Daten zu wenigstens einer Eigenschaft des Diagnoseziels (2) für das Diagnoseobjekt (5) von wenigstens einer Datenquelle (4) zur Verfügung gestellt werden, und
bei dem für die wenigstens eine Datenquelle (4) wenigstens eine Validitätsprüfung (11) durchgeführt wird.

2. Verfahren nach Anspruch 1,
**dadurch gekennzeichnet, dass**
ein Ergebnis der Validitätsprüfung (11) und ein Prüfzeitpunkt (13) der Validitätsprüfung (11) abgespeichert werden.

3. Verfahren nach Anspruch 1 oder 2,
**dadurch gekennzeichnet, dass**
bei einem vorbestimmten Ergebnis der Validitätsprüfung (11) eine vorbestimmte Anzeige am Diagnoseobjekt (5) abgebildet wird.

4. Verfahren nach Anspruch 3,
**dadurch gekennzeichnet, dass**
als zumindest ein Teil der Anzeige der Prüfzeitpunkt (13) der Validitätsprüfung (11) abgebildet wird.

5. Verfahren nach einem der oben genannten Ansprüche,
**dadurch gekennzeichnet, dass**
als Teil der Validitätsprüfung (11) eine Verbindung zur Datenquelle (4) geprüft wird.

6. Verfahren nach einem der oben genannten Ansprüche,
**dadurch gekennzeichnet, dass**
als Teil der Validitätsprüfung (11) wenigstens eine Regel und/oder ein Algorithmus zur Berechnung der Datenvalidität angewendet werden.

7. Verfahren nach einem der oben genannten Ansprüche,
**dadurch gekennzeichnet, dass**
die Validitätsprüfung (11) im Wesentlichen kontinuierlich oder regelmäßig durchgeführt wird.

8. Verfahren nach einem der oben genannten Ansprüche,
**dadurch gekennzeichnet, dass**
bei einer festgestellten Invalidität der Datenquelle (4) die letzten zur Verfügung gestellten Daten verwendet werden.

9. Computerprogrammprodukt mit Programmbefehlen zur Durchführung des Verfahrens nach einem der Ansprüche 1 - 8.

10. Bereitstellungsvorrichtung für das Computerprogrammprodukt nach Anspruch 9, wobei die Bereitstellungsvorrichtung das Computerprogrammprodukt speichert und/oder bereitstellt.

11. Diagnoseeinrichtung (3) für eine Anlage, insbesondere für eine verkehrstechnische Anlage (1),
mit wenigstens einem Diagnoseobjekt (5), das zum Abbilden von wenigstens einem Diagnoseziel (2) der Anlage (1) und zum Verarbeiten von Daten zu wenigstens einer Eigenschaft des Diagnoseziels (2) ausgebildet ist,
wobei die Diagnoseeinrichtung (3) ausgebildet ist, die Daten zu der wenigstens einen Eigenschaft des Diagnoseziels (2) von wenigstens einer Datenquelle (4) zu verarbeiten,
und mit wenigstens einer Prüfeinrichtung (13), die zum Durchführen wenigstens einer Validitätsprüfung (11) für die wenigstens eine Datenquelle (4) ausgebildet ist.

12. Diagnoseeinrichtung (3) nach Anspruch 11,
**dadurch gekennzeichnet, dass**
die Diagnoseeinrichtung (3) wenigstens eine Speichereinrichtung (9) aufweist, in der wenigstens ein Ergebnis der Validitätsprüfung (11) und/oder ein Prüfzeitpunkt (13) der Validitätsprüfung (11) abgespeichert sind.

13. Diagnoseeinrichtung (3) nach Anspruch 11 oder 12,
**dadurch gekennzeichnet, dass**
die Diagnoseeinrichtung (3) ausgebildet ist, bei einer festgestellten Invalidität der Datenquelle (4) die letzten zur Verfügung gestellten Daten verwendet.

14. Verkehrstechnische Anlage (1),
mit wenigstens einem Diagnoseziel (2),
mit wenigstens einer Datenquelle (4), die zum Liefern von Daten zu wenigstens einer Eigenschaft des Diagnoseziels (2) ausgebildet ist, und
mit wenigstens einer Diagnoseeinrichtung (3),
**dadurch gekennzeichnet, dass**
die Diagnoseeinrichtung (3) nach einem der oben genannten Ansprüche 11 bis 13 ausgebildet ist.

15. Anlage (1) nach Anspruch 14,
**dadurch gekennzeichnet, dass**
die Anlage (1) als eisenbahntechnische Anlage ausgebildet ist.
